Europäisches Patentamt

European Patent Office

Office européen des brevets

(19)

(11) Veröffentlichungsnummer: **0 069 979**
**B2**

(12) **NEUE EUROPÄISCHE PATENTSCHRIFT**

(45) Veröffentlichungstag der neuen Patentschrift:
23.01.91

(51) Int. Cl.⁵: **H 03 J 5/24, H 03 H 11/30**

(21) Anmeldenummer: **82106058.9**

(22) Anmeldetag: **07.07.82**

(54) Antennenanpasseinrichtung.

(30) Priorität: **11.07.81 DE 3127566**

(43) Veröffentlichungstag der Anmeldung:
**19.01.83 Patentblatt 83/03**

(45) Bekanntmachung des Hinweises auf die
Patenterteilung:
**03.12.86 Patenblatt 86/49**

(45) Bekanntmachung des Hinweises auf die
Entscheidung u¨ber den Einspruch:
**23.01.91 Patentblatt 91/04**

(84) Benannte Vertragsstaaten:
**BE DE FR GB NL**

(56) Entgegenhaltungen:
**DE-A-2 616 185      US-A-3 794 941**
**US-A-3 129 386      US-A-3 906 405**
**US-A-3 566 273      US-A-4 138 654**

**NACHRICHTENTECHNISCHE ZEITSCHRIFT
N.T.Z., Band 23, Nr. 9, September 1970, Seiten
460-461, Berlin, DE; F. LANDSTORFER:
"Automatische Resonanzeinstellung bei Sende-
und Empfangsantennen"**

(73) Patentinhaber: **Rohde & Schwarz GmbH & Co.
KG
Mühldorfstrasse 15
D-8000 München 80 (DE)**

(72) Erfinder: **Huber, Franz Reinhold
Waldstrasse 13
D-8019 Assling (DE)**
Erfinder: **Stark, Axel
Plettstrasse 67
D-8000 München 83 (DE)**

(74) Vertreter: **Graf, Walter, Dipl.-Ing.
Sckellstrasse 1
D-8000 München 80 (DE)**

(56) References cited:
**Neues von Rohde und Schwarz 46 Dez./Jan.
1970/71**

EP 0069 979 B2

## Beschreibung

Die Erfindung betrifft eine Antennenanpasseinrichtung laut Oberbegriff des Hauptanspruches.

Eine Antennenanpasseinrichtung dieser Art ist bekannt (US-PS 3 129 386). Hierbei sind genau soviel abstimmbare Spulen wie Sendefrequenzen vorgesehen, die über synchron betätigbare Mehrfachschalter mit entsprechenden Kondensatoren zu Anpasszweigen zusammenschaltbar sind, so dass für jede einstellbare Sendefrequenz zwischen Sender und Antenne ein auf die gleiche Frequenz abgestimmter Anpasszweig eingeschaltet wird. Eine solche bekannte Antennenanpasseinrichtung wäre für Sender, die sehr schnell zwischen aufeinanderfolgenden Sendefrequenzen umschaltbar sind, nicht geeignet. Moderne Sender, wie sie in künftigen Funkübertragungsverfahren mit sehr schnellem sprunghaften Frequenzwechsel nach einem vorbestimmten Frequenzschema benutzt werden, können im Bereich von Millisekunden oder sogar Mikrosekunden in der Frequenz umgeschaltet werden. Ein gleich schnelles Umschalten wäre bei der bekannten Einrichtung in den Anpasszweigen nicht durchführbar. Die Anpasszweige stellen Schwingkreise hoher Güte dar, in denen hohe Bindleistungen auftreten. Zur Umschaltung der Spulen und Kondensatoren müssen daher Schalter verwendet werden, die relativ hohe Leistungen schalten können, vor allem dann, wenn die Einrichtung für einen Sender mit relativ grosser Ausgangsleistung benutzt werden soll. Solche Schalter für höhere Leistungsbelastungen, beispielsweise übliche Vakuumrelais, besitzen jedoch relativ langsame Schaltzeiten. Modernere schnell schaltende Halbleiterschalter, wie sie im Sender verwendet werden, und wodurch die oben erwähnten kurzen Umschaltzeiten möglich sind, können wegen der höheren Leistungsbelastung nicht in solchen Anpassgeräten verwendet werden. Die Schnelligkeit der Frequenzumschaltung wird also bei Einrichtungen dieser Art bisher ausschliesslich durch die Schnelligkeit bestimmt, mit welcher das Anpassgerät in der Frequenz umschaltbar ist, in der Praxis sind höchstens Umschaltzeiten von einigen Millisekunden erreichbar. Dies ist für verschiedene oben erwähnte Anwendungsfälle, beispielsweise im militärischen Bereich, zu langsam.

Es ist daher Aufgabe der Erfindung, eine Antennenanpasseinrichtung für einen Schnell auf unterschiedliche Sendefrequenzen umschaltbaren Hochfrequenzsender zu schaffen, die genauso schnell wie der Sender in der Frequenz abstimmbar ist.

Diese Aufgabe wird ausgehend von einer Antennenanpasseinrichtung laut Oberbegriff des Hauptanspruches durch dessen kennzeichnende Merkmale gelöst. Vorteilhafte Weiterbildungen ergeben sich aus den Unteransprüchen.

Durch die erfindungsgemässe Massnahme, zwei oder mehrere getrennte Antennenanpasszweige vorzusehen, ist es möglich, während des Sendens über den einen auf die momentane Sendefrequenz abgestimmten Zweig einen anderen Zweig auf die im Frequenzschema nächstfolgende Frequenz abzustimmen oder sogar mehrere andere Zweige auf die im Frequenzschema nächstfolgenden Frequenzen abzustimmen, so dass bei der anschliessenden Frequenzumschaltung des Senders nur noch über die schnell schaltbaren Schalter der nächste schon abgestimmte Zweig angeschaltet werden muss. Die zum Anschalten der Zweige vorgesehenen schnell schaltbaren Schalter sind beispielsweise genauso wie im Sender als Halbleiterschalter ausgeführt. Obwohl in den einzelnen Anpasszweigen also nach wie vor relativ langsame Schalter zum Abstimmen der Blindelemente auf die vorbestimmten Frequenzen vorgesehen sind, kann mit der erfindungsgemässen Einrichtung sehr schnell von einer Sendefrequenz auf die nächste umgeschaltet werden. Es ist damit möglich, auch solche Antennenanpasseinrichtungen genauso schnell wie moderne Sender im Millisekunden-bzw. Mikrosekundenbereich in der Frequenz umzuschalten. Nachdem über die Steuereinrichtung die Frequenzfolge bekannt ist, die ja auch im Empfänger bekannt sein muss, ist es so beispielsweise schon mit zwei Zweigen möglich, das Anpassgerat schnell in der Frequenz umzuschalten. Zum Abstimmen der Anpasszweige steht jeweils die Zeit zur Verfügung, die zum Abstimmen des Senders und zur Ausstrahlung der Information auf einer vorgegebenen Frequenz zur Verfügung steht. Ist diese Zeit nicht ausreichend zur Abstimmung eines Antennenanpasszweiges, so ist es zweckmässig, mehr als zwei Anpasszweige vorzusehen und diese nacheinander auf die verschiedenen Frequenzen abzustimmen. Im allgemeinen genügt es, nur eingangsseitig die Anpasszweige über entsprechend schnelle Schalter mit dem Senderausgang zu verbinden, ausgangsseitig können die einzelnen Zweige zusammengefasst mit der Antenne verbunden sein. Um jedoch gegebenenfalls ausgangsseitig gewisse Rückwirkungen oder Leistungsbeeinflussungen der einzelnen Zweige zu vermeiden, kann es vorteilhaft sein, auch ausgangsseitig jeweils schnelle Schalter vorzusehen, über die jeweils nur der gerade wirksame Zweig mit der Antenne verbunden wird.

Die erfindungsgemässe Einrichtung ist insbesondere von Vorteil für Sendeantennen, deren Sender nach dem Frequenzsprungverfahren arbeitet. Hierfür wurden bisher meist Breitbandantennen benutzt, die mechanisch sehr lang und breit sind. Solche bekannten Antennensysteme sind beispielsweise im militärischen Bereich auf Fahrzeugen sehr ungeeignet. Gemäss der Erfindung ist es möglich, auch für solche Anwendungsfälle Antennen zu benutzen, die klein gegenüber der Wellenlänge sind und daher gut geeignet sind für den mobilen Einsatz.

Die Erfindung wird im folgenden anhand einer schematischen Zeichnung an einem Ausführungsbeispiel näher erläutert.

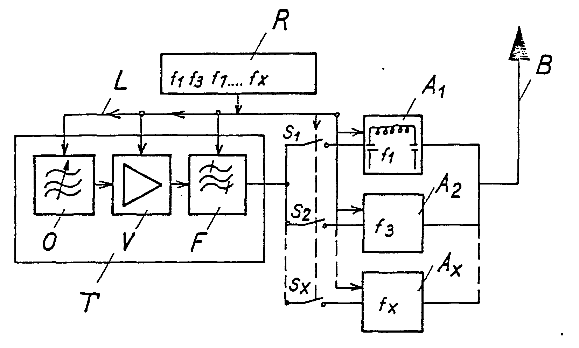

Die Figur zeigt einen üblichen Hochfrequenzsender T beispielsweise für den Frequenzbereich zwischen 20 und 80 MHz, er besteht aus einem abstimmbaren Oszillator O, einem Leistungsverstärker V und einem nachgeschalten abstimmbaren Filter F. Die einzelnen frequenz-bestimmenden Elemente des Senders T sind über eine Steuerleitung L durch eine Steuereinrichtung R abstimmbar. In der Steuereinrichtung R ist das gewünschte Frequenzschema einprogrammiert, in dem gezeigten Ausführungsbeispiel ist beispielsweise eingegeben, dass der Sender T sehr schnell in der Frequenzfolge f1, f3, f7 ... fx umgeschaltet werden soll, also in einer vorbestimmten Reihenfolge der Sendefrequenz des ausgewählten Frequenzbandes. Der Ausgang des Senders steht über sehr schnelle Schalter S1, S2, Sx mit einzelnen Abstimmzweigen A1, A2, Ax in Verbindung, die ausgangsseitig mit der Antenne B verbunden sind. Gegebenenfalls können auch zwischen Antenne B und Anpasszweigen noch zusätzliche synchron mit den eingangsseitigen Schaltern geschaltete schnelle Schalter angeordnet sein. Die Schalter S1, S2, Sx sind vorzugsweise Halbleiterschalter, die im Mikrosekundenbereich schaltbar sind. Jeder Anpasszweig A1, A2, Ax ist in bekannter Weise ausgebildet und seine Blindwiderstände sind durch relativ langsame Leistungsschalter, beispielsweise Reedrelais, wiederum gesteuert durch die Steuereinrichtung R auf die verschiedenen dort eingegebenen Sendefrequenzen abstimmbar. Die eingespeicherte Frequenzfolge der Steuereinrichtung R liegt fest, sie muss ja auch auf der Empfangsseite bekannt sein. Angenommen, der erste Anpasszweig A1 ist gesteuert über die Steuereinrichtung R auf die Frequenz f1 abgestimmt, genauso wie der Sender T, und der Schalter S1 ist geschlossen, d.h. der Sender sendet über den Anpasszweig A1 und die Antenne B. Während dieser Sendezeit wird der zweite Anpasszweig A2 auf die im Schema nächstfolgende Frequenz f3 abgestimmt. Wird dann über die Steuereinrichtung R der Sender T auf die nächstfolgende Sendefrequenz f3 geschaltet, so wird gleichzeitig S1 geöffnet und S2 geschlossen, also der vorher auf die Frequenz f3 abgestimmte Anpasszweig A2 zur Antenne B durchgeschaltet. Sind drei oder mehrere Anpasszweige vorgesehen, so kann hierdurch natürlich die Einstellzeit des Anpassgerätes noch entsprechend verkürzt werden.

**Patentansprüche**

1. Antennenanpasseinrichtung für einen Hochfrequenzsender (T), der mittels einer Steuereinrichtung (R) nach einem vorbestimmten Frequenzschema auf unterschiedliche Sendefrequenzen umschaltbar ist, mit zwei oder mehreren auf unterschiedliche Frequenzen abstimmbaren Anpasszweigen (A1 und A2 oder A1 bis Ax), die über Schalter (S1 bis Sx), welche durch die Steuereinrichtung (R) gesteuert sind, zwischen Sender (T) und Antenne (B) schaltbar sind, dadurch gekennzeichnet, daß schnellschaltende Schalter (S1 bis Sx) benutzt sind, die eine Frequenzumschaltung im msec-Bereich oder darunter ermöglichen, und dass auch die Anpasszweige (A1 und A2 oder A1 bis Ax) durch die Steuereinrichtung (R) in der Frequenz abstimmbar sind, so dass über die Steuereinrichtung (R) während des Sendens über einen auf die momentane Sendefrequenz abgestimmten Anpasszweig (z.B. A1) der andere Zweig (z.B. A2) auf die im Frequenzschema nächstfolgende Frequenz abgestimmt wird bzw. bei mehr als zwei Anpaßzweigen (A1 bis Ax) die anderen Anpasszweige (A2 bis Ax) auf im Frequenzschema nächstfolgende Frequenzen abgestimmt werden.

2. Einrichtung nach Anspruch 1 dadurch gekennzeichnet, dass die Schalter (S1 bis Sx) schnellschaltende Halbleiterschalter sind.

**Revendications**

1. Dispositif d'adaptation d'antennes pour un émetteur haute fréquence (T), qui est susceptible d'être commuté par un moyen de commande (R) sur différentes fréquences d'émission selon un schéma de fréquence prédéterminé, avec deux ou plusieurs dérivations d'adaptation (A1 et A2) ou bien (A1 à Ax) susceptibles d'être accordées sur différentes fréquences et qui peuvent être branchées entre l'émetteur (T) et l'antenne (B) par l'intermédiaire de commutateurs (S1 à Sx) commandés par le moyen de commande (R), dispositif caractérisé en ce qu'on utilise des commutateurs à commutation rapide (S1 à Sx) qui permettent une commutation de fréquence dans le domaine des millisecondes ou au-dessous, et en ce que les dérivations d'adaptation (A1 à A2) ou bien A1 à Ax) sont également susceptibles d'être accordées sur la fréquence par le moyen de commande (R), de sorte que par l'intermédiaire de ce moyen de commande (R), pendant l'émission par l'intermédiaire d'une dérivation d'adaptation accordée sur la fréquence du moment (par exemple A1), l'autre dérivation d'adaptation (par exemple A2) est accordée sur la fréquence immédiatement suivante dans le schéma de fréquence, ou bien que, dans le cas de plus de deux dérivations d'adaptation (A1 à Ax), les autres dérivations d'adaptation (A2 à Ax) sont accordées sur les fréquences immédiatement suivantes dans le schéma de fréquence.

2. Dispositif selon la revendication 1, caractérisé en ce que les commutateurs (S1 à Sx) sont des commutateurs à semi-conducteurs assurant une commutation rapide.

**Claims**

1. Antenna matching circuit for a radio-frequency transmitter (T) which is adapted to be switched to different transmitting frequencies by means of a control unit (R) in accordance with a predetermined frequency pattern, comprising two or more matching branch circuits (A1 and A2 or A1 to Ax) adapted to be switched between transmitter (T) and antenna (B) by means of switches (S1 to Sx) which are controlled through the control unit (R), characterised in that there are used high-speed switches (S1 to Sx), which allow frequency switching in the range of msec or below, and that the matching branch circuits (A1 and A2 or A1 to Ax) are likewise adapted to be frequency tuned by said control unit (R) so that during transmission *via* one matching branch circuit (e.g. A1) matched to the current transmission frequency the other branch circuit (e.g. A2) is tuned by said control unit (R) to the next-following frequency of the frequency pattern or, respectively, in case of more than two matching branch circuits (A1 to Ax) the other matching branch circuits (A2 to Ax) are tuned to the next-following frequencies of the frequency pattern.

2. A circuit as claimed in claim 1, characterised in that the switches (S1 to Sx) are high-speed semiconductor switches.